# EUROPÄISCHE PATENTANMELDUNG

(11) **EP 1 933 224 A1**
(43) Veröffentlichungstag der Anmeldung: **18.06.2008**
(21) Anmeldenummer: 07119110.0
(22) Anmeldetag: 23.10.2007
(51) Int. Cl.: G06F 1/20, G06F 1/18, B01D 46/10

(54) **Computeranordnung und Staubfilteranordnung mit einem Staubfilter**

(30) Priorität: 15.12.2006 DE 102006059425
(71) Anmelder: Fujitsu Siemens Computers GmbH, 80807 München (DE)
(72) Erfinder: Rösler, Lutz, 99610, Leubingen (DE)
(74) Vertreter: Epping - Hermann - Fischer

(57) **Zusammenfassung**

Die Erfindung betrifft eine Computeranordnung (1) aufweisend ein Gehäuse (2) mit wenigstens einer Gehäusewand (3) bestehend aus einem metallischen Material, wobei in der wenigstens einen Gehäusewand (3) wenigstens eine Lufteintrittsöffnung (4) ausgebildet ist, durch die Luft von einem in Inneren des Gehäuses (2) angeordneten Lüfter (6) ansaugbar ist, und einen Staubfilter (12) zum Filtern von Staub aus einem Kühlluftstrom. Die Computeranordnung (1) ist gekennzeichnet durch einen rahmenartige Halterung (11) zur Aufnahme des Staubfilters (12), wobei die rahmenartige Halterung (11) wenigstens ein magnetisches Halteelement aufweist, das die rahmenartige Halterung (11) außen an der wenigstens einen Gehäusewand (3) festhält.

Die Erfindung betrifft außerdem eine Staubfilteranordnung (10) zur Verwendung in der oben genannten Computeranordnung (1).

## Beschreibung

Die Erfindung betrifft eine Computeranordnung aufweisend ein Gehäuse mit wenigstens einer Gehäusewand bestehend aus einem metallischen Material, wobei in der wenigstens einen Gehäusewand wenigstens eine Lufteintrittsöffnung ausgebildet ist, durch die Luft von einem im Inneren des Gehäuses angeordnetem Lüfter ansaugbar ist, und einen Staubfilter zum Filtern von Staub aus einem Kühlluftstrom.

Die Erfindung betrifft des Weiteren eine Staubfilteranordnung mit einem Staubfilter für eine in einer metallischen Gehäusewand ausgebildeten Lufteintrittsöffnung.

Computeranordnungen werden in der Regel durch einen Luftstrom gekühlt, der von einem Gehäuse-, Bauteil- oder Netzteillüfter von außen in ein Gehäuse angesogen wird, dort angeordnete, Hitze erzeugende Komponenten, wie etwa Prozessoren, Festplatten oder Spannungsregler, kühlt und die auf diese Weise erhitzte Luft durch eine Luftaustrittsöffnung aus dem Inneren des Computergehäuses befördert.

Abhängig von der Leistungsfähigkeit des Computers und der davon abhängigen Abwärme sowie der Umgebungstemperatur der Computeranordnung werden im Betrieb verhältnismäßig große Luftvolumen durch die Computeranordnung befördert. Zusammen mit der Luft werden auch Fremdstoffe, insbesondere Staubfasern in das Computergehäuse angesogen. Bedingt durch elektrostatische Aufladung einzelner Komponenten, mechanischen Hindernissen in dem Computergehäuse sowie durch den Kontakt mit besonders heißen Bauteilen sammelt sich der Staub im Inneren des Computergehäuses an und behindert auf diese Weise den Kühlluftstrom. Dies wiederum führt zu einer Verminderung der Kühlleistung und einer damit einhergehenden Gefahr der Überhitzung.

Elektronische Temperaturüberwachungssysteme besonders gefährdeter Komponenten, wie etwa des Prozessors, führen oftmals dazu, dass die Komponenten ganz abgeschaltet werden oder ein zur Kühlung verwendeter Ventilator mit erhöhter Drehzahl betrieben wird, was zu einer erhöhten Geräuschentwicklung führt.

Zur Vermeidung der oben genannten Probleme ist es bekannt, andere Kühlmittel einzusetzen. Insbesondere Wasserkühlsysteme, oder Systeme mit außen liegenden, großflächigen Kühlkörpern, die über Wärmeleitrohre mit den Hitze erzeugenden Komponenten verbunden sind, bedürfen oft keiner Zwangskühlung durch einen Lüfter, sodass die oben geschilderten Probleme hier nicht auftreten. Solche Kühlanordnungen sind jedoch verhältnismäßig aufwändig herzustellen und zu montieren und eignen sich damit nicht für besonders einfache oder preisgünstige Systeme.

Andere Lösungen des Problems sehen einen fest in dem Computergehäuse angeordneten Staubfilter aus einem Schaumstoff oder Vliesmaterial vor. Staub und andere Fremdpartikel bleiben in dem Filter hängen und können sich so nicht im Inneren des Computergehäuses anlagern. Durch diesen Filtereffekt wird jedoch der Filter selbst verstopft, sodass die Kühlleistung mit zunehmender Verschmutzung nachlässt, was wiederum zu den oben geschilderten Problemen führt.

Aufgabe der Erfindung ist es daher, eine verbesserte Computeranordnung und eine Staubfilteranordnung zu beschreiben, bei denen die oben beschriebenen Probleme vermindert werden beziehungsweise nicht auftreten. Dabei soll eine solche Staubfilteranordnung besonders einfach und auch nachträglich an ein bestehendes Gehäuse einer Computeranordnung angebracht und im Betrieb gereinigt werden können.

Die zugrunde liegende Aufgabe wird durch eine Computeranordnung der oben genannten Art gelöst, die durch eine rahmenartige Halterung zur Aufnahme des Staubfilters gekennzeichnet ist, wobei die rahmenartige Halterung wenigstens ein magnetisches Halteelement aufweist, das die rahmenartige Halterung außen an der wenigstens einen Gehäusewand festhält.

Durch Verwendung einer zusätzlichen, an der Außenseite des Gehäuses angeordneten rahmenartigen Halterung, die mittels eines magnetischen Halteelementes an der metallischen Gehäusewand befestigt ist, wird es möglich, einen Staubfilter auch nachträglich an der Außenseite eines Computergehäuses zu befestigen. Ein Eingriff in das Gehäuse ist hierzu nicht nötig. Auf diese Weise bleibt der Filter leicht erreichbar, sodass er im Bedarfsfall ausgewechselt oder von außen gereinigt werden kann.

Dabei macht sich die Erfindung zunutze, dass Computergehäuse zur Vermeidung von elektromagnetischer Störstrahlung aus metallischen Materialien gefertigt sind, sodass eine Befestigung mittels magnetischen Halteelementen besonders einfach möglich ist.

Gemäß einer vorteilhaften Ausgestaltung weist die rahmenartige Halterung wenigstens einen Zentrierbolzen auf, der in eine Öffnung der wenigstens einen Gehäusewand eingreift und den Staubfilter auf der Gehäusewand festlegt. Durch Verwendung eines zusätzlichen Zentrierbolzens, kann die Position des Staubfilters auf der Gehäusewand besonders einfach festgelegt und die rahmenartige Halterung zusätzlich fixiert werden.

Die Erfindung wird ebenso gelöst durch eine Staubfilteranordnung mit einem Staubfilter für eine in einer metallischen Gehäusewand ausgebildeten Lufteintrittsöffnung, die durch eine rahmenartige Halterung zur Aufnahme des Staubfilters gekennzeichnet ist, wobei die rahmenartige Halterung wenigstens ein magnetisches Halteelement aufweist, das dazu eingerichtet ist, den Rahmen an der wenigstens einen Gehäusewand festzuhalten.

Gemäß einer vorteilhaften Ausgestaltung der Staubfilteranordnung ist der Staubfilter in Form einer Lochfolie ausgebildet. Die Verwendung einer Lochfolie anstelle eines Schaumstofffiltermediums ermöglicht eine besonders einfache Reinigung und Herstellung des Staubfilters. Zudem kann ein Staubfilter in Form einer Lochfolie besonders dünn ausgestaltet werden, sodass die Staubfilteranordnung auf ästhetisch ansprechende Weise in das Gehäusedesign integriert werden kann.

Weitere Einzelheiten und Ausgestaltungen der Erfindung sind in den Unteransprüchen angegeben.

Die Erfindung wird nachfolgend an einem Ausführungsbeispiel anhand der Zeichnungen näher erläutert. In den Zeichnungen zeigen:
Figur 1 eine perspektivische Ansicht einer Computeranordnung mit einer Staubfilteranordnung,
Figur 2 eine Draufsicht und zugehörige Querschnitte durch eine Staubfilteranordnung und
Figur 3 eine Draufsicht auf eine Gehäusewand einer Computeranordnung mit einer Lufteintrittsöffnung.

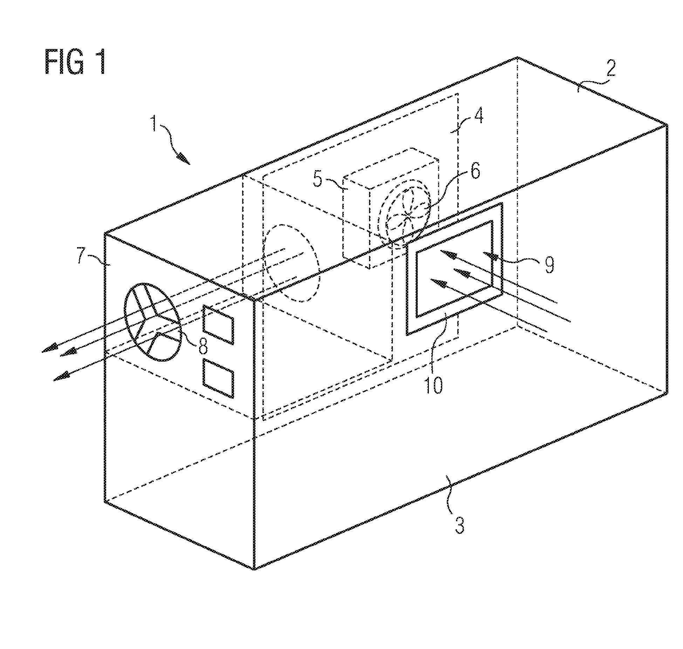

Figur 1 zeigt eine perspektivische Ansicht einer Computeranordnung 1. Die Computeranordnung 1 umfasst ein Gehäuse 2 mit einer Gehäusewand 3, das aus einem metallischen Material, zum Beispiel Stahlblech, geformt ist.

In dem Gehäuse 1 ist eine Systemplatine 4 mit darauf befindlichen, Hitze erzeugenden Komponenten 5 angeordnet. Im dargestellten Ausführungsbeispiel handelt es sich bei der Hitze erzeugenden Komponente 5 um einen Prozessor, auf dem eine Kühlanordnung bestehend aus einem nicht dargestellten Kühlkörper und einem Lüfter 6 angeordnet sind.

Außerdem ist in dem Gehäuse 2 ein Netzteil 7 angeordnet, welches in dem Gehäuse 2 befindliche, erwärmte Luft durch einen Netzteillüfter 8 aus dem Gehäuse 2 herausbläst.

In der im Bild vorderen Gehäusewand 3 befindet sich im Bereich der Hitze erzeugenden Komponente 5 eine Lufteintrittsöffnung 9, die mit einer Staubfilteranordnung 10 abgedeckt ist. Die Staubfilteranordnung 10 ist mittels eines in der Figur 1 nicht dargestellten magnetischen Halteelementes an der metallischen Gehäusewand 3 festgelegt.

Die Staubfilteranordnung 10 filtert den durch die Lufteintrittsöffnung 9 eintretenden Luftstrom, der von dem Lüfter 6 angesaugt wird und durch den Netzteillüfter 8 wieder aus dem Gehäuse 2 herausgeblasen wird. Selbstverständlich sind auch Ausgestaltungen mit nur einem Lüfter oder weiteren Lüftern und zugehörigen Luftein- und Austrittsöffnungen möglich.

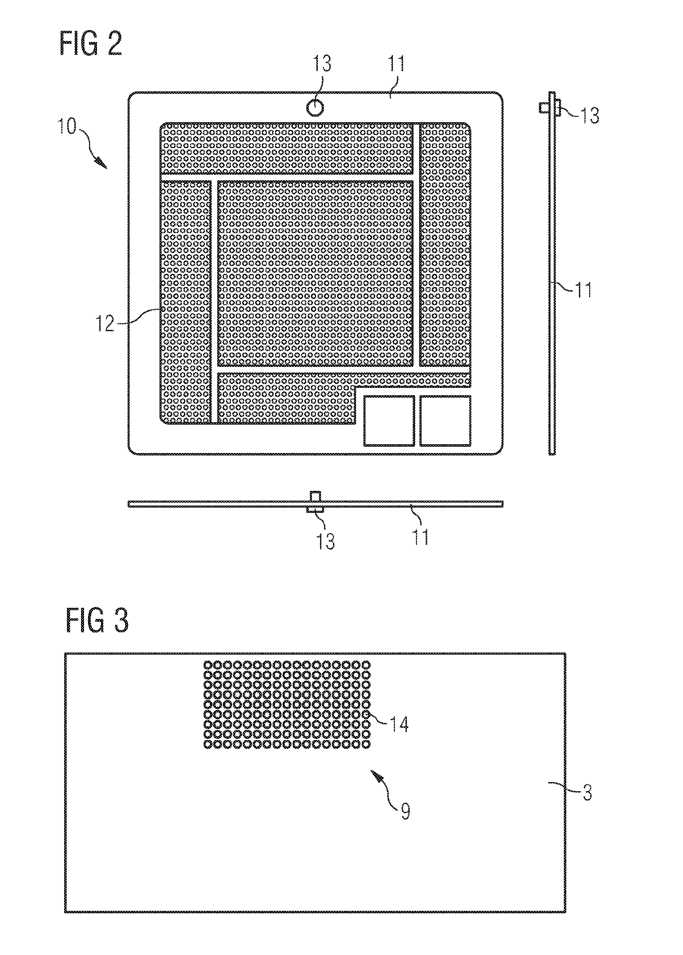

In der Figur 2 ist die Staubfilteranordnung 10 im Detail dargestellt. Die Staubfilteranordnung 10 umfasst eine rahmenartige Halterung 11 sowie einen Staubfilter 12 zum Filtern von Staub aus einem Kühlluftstrom. Im dargestellten Ausführungsbeispiel ist die rahmenartige Halterung 11 aus einem magnetischen Material hergestellt, die die gesamte Staubfilteranordnung 10 an der Gehäusewand 3 festhält.

Alternativ ist es auch möglich einzelne oder mehrere magnetische Halteelemente, zum Beispiel auf einen nicht magnetischen Rahmen aufgebrachte Magnetscheiben, zur Festlegung der rahmenartigen Halterung 11 an der Gehäusewand 3 zu verwenden.

Der Staubfilter 12 ist zwischen der rahmenartigen Halterung 11 und der Gehäusewand 3 befestigt. Hierzu kann dieser beispielsweise zwischen der rahmenartigen Halterung 11 und der Gehäusewand 3 eingeklemmt werden. Alternativ ist es auch möglich, den Staubfilter 12 mir der rahmenartigen Halterung 11 zu verkleben. In einer weiteren Ausgestaltung wird der Staubfilter 12 eine in der Figur 2 nicht dargestellte Vertiefung der rahmenartigen Halterung 11 eingelegt.

Zur Zentrierung und verbesserten Halterung der Staubfilteranordnung 10 an der Gehäusewand 3 kann zusätzlich ein Zentrierbolzen 13 vorgesehen sein. Im Ausführungsbeispiel ist hierzu ein einfacher Plastikdübel an der rahmenartigen Halterung 11 befestigt.

Bei dem Staubfilter 12 handelt es sich im Ausführungsbeispiel um eine Kunststofflochfolie, die durch einfaches Abwischen der Oberfläche gereinigt werden kann. Selbstverständlich ist es auch möglich, den Staubfilter 12 durch Entfernen der rahmenartigen Halterung 11 aus der Staubfilteranordnung 10 zu entnehmen und zu waschen.

Versuche zur Verminderung von Staubanlagerungen im Inneren eines Gehäuses 2 haben ergeben, dass es besonders vorteilhaft ist, wenn die Lochfolie Löcher mit einem Durchmesser von etwa 0,8 mm aufweist. Auf diese Weise können verhältnismäßig große Staubpartikel aus dem Luftstrom gefiltert werden, ohne dass es zu einer merklichen Behinderung des Luftstroms durch die Lufteintrittsöffnung 9 kommt. Auf diese Weise kann eine Erhöhung der Drehzahl des Lüfters 6 vermieden werden, so dass auch die Geräuschbelastung durch die Computeranordnung 1 nicht vergrößert wird.

In dem Ausführungsbeispiel besitzt die Lochfolie eine Dicke von wenigstens 0,47 mm und weist etwa 450 Löcher pro Zoll auf. Eine derartige Ausgestaltung der Lochfolie ermöglicht eine effektive Filterung bei guter Kühlluftführung durch die Computeranordnung 1 und erlaubt außerdem eine ästhetisch ansprechende, extrem flache Gestaltung der Staubfilteranordnung 10. Dies wird insbesondere durch die Querschnittszeichnungen, die ebenfalls in Figur 2 dargestellt sind, deutlich.

Figur 3 zeigt die Gehäusewand 3 mit der darin befindlichen Lufteintrittsöffnung 9 im Detail. Bei der Lufteintrittsöffnung 9 handelt es sich um ein Lochraster, das eine Vielzahl von Löchern 14 aufweist.

Gemäß einer vorteilhaften Ausgestaltung der Erfindung, wird eines der Löcher 14 der Lufteintrittsöffnung 9 zur Festlegung der Staubfilteranordnung 10 auf der Gehäusewand 3 verwendet. Dazu wird der Zentrierbolzen 13 einfach in ein mittig gelegenes Loch 14 im oberen Bereich der Lufteintrittsöffnung 9 eingeführt, so dass die Staubfilteranordnung 10 sicher im Bereich der Lufteintrittsöffnung festgelegt ist. Durch der Verwendung bereits vorhandener Löcher 14 der Lufteintrittsöffnung 9, kann die beschriebene Staubfilteranordnung 10 auch in Verbindung mit herkömmlichen Computeranordnungen 1 verwendet werden.

In einer weiteren, vorteilhaften Ausgestaltung der Erfindung verfügt der Zentrierbolzen 13 über ein Klemm- oder Rastmittel, beispielsweise in Form einer oder mehrerer Spreizbacken, die die Staubfilteranordnung 10 nach Einführen des Zentrierbolzens 3 in dem Loch 14 zusätzlich festhalten.

### Bezugszeichenliste

- 1: Computeranordnung
- 2: Gehäuse
- 3: Gehäusewand
- 4: Systemplatine
- 5: Hitze erzeugende Komponente
- 6: Lüfter
- 7: Netzteil
- 8: Netzteillüfter
- 9: Lufteintrittsöffnung
- 10: Staubfilteranordnung
- 11: Rahmenartige Halterung
- 12: Staubfilter
- 13: Zentrierbolzen
- 14: Loch

## Patentansprüche

1. Computeranordnung (1) aufweisend
- ein Gehäuse (2) mit wenigstens einer Gehäusewand (3) bestehend aus einem metallischen Material, wobei in der wenigstens einen Gehäusewand (3) wenigstens eine Lufteintrittsöffnung (9) ausgebildet ist, durch die Luft von einem im Inneren des Gehäuses (2) angeordneten Lüfter (6) ansaugbar ist, und
- einen Staubfilter (12) zum Filtern von Staub aus einem Kühlluftstrom,
**gekennzeichnet durch**
- eine rahmenartige Halterung (11) zur Aufnahme des Staubfilters (12), wobei die rahmenartige Halterung (11) wenigstens ein magnetisches Halteelement aufweist, das die rahmenartige Halterung (11) außen an der wenigstens einen Gehäusewand (3) festhält.

2. Computeranordnung (1) nach Anspruch 1,
**dadurch gekennzeichnet, dass**
die rahmenartige Halterung (11) aus einem magnetischen Material gefertigt ist und als magnetisches Halteelement wirkt.

3. Computeranordnung (1) nach Anspruch 1 oder 2,
**dadurch gekennzeichnet, dass**
die rahmenartige Halterung (11) wenigstens einen Zentrierbolzen (13) aufweist, der in eine Öffnung der wenigstens einen Gehäusewand (3) eingreift und den Staubfilter (12) auf der Gehäusewand (3) festlegt.

4. Computeranordnung (1) nach Anspruch 3,
**dadurch gekennzeichnet, dass**
die Lufteintrittsöffnung (9) in Form eines Gitters, Netzes oder Lochrasters mit einer Vielzahl von Löchern (14) ausgebildet ist und der wenigstens eine Zentrierbolzen (13) in ein Loch (14) des Gitters, des Netzes beziehungsweise des Lochrasters eingreift.

5. Computeranordnung (1) nach Anspruch 3 oder 4,
**dadurch gekennzeichnet, dass**
der wenigstens eine Zentrierbolzen (13) wenigstens ein Rast- oder Klemmmittel aufweist, das die rahmenartige Halterung (11) zusätzlich an der wenigstens einen Gehäusewand (3) festhält.

6. Staubfilteranordnung (10) mit einem Staubfilter (12) für eine in einer metallischen Gehäusewand (3) ausgebildeten Lufteintrittsöffnung (9),
**gekennzeichnet durch**
eine rahmenartige Halterung (11) zur Aufnahme des Staubfilters (12), wobei die rahmenartige Halterung (11) wenigstens ein magnetisches Halteelement aufweist, das dazu eingerichtet ist, die rahmenartige Halterung (11) an der wenigstens einen Gehäusewand (3) festzuhalten.

7. Staubfilteranordnung (10) nach Anspruch 6,
**dadurch gekennzeichnet, dass**
der Staubfilter (12) in Form einer Lochfolie ausgebildet ist.

8. Staubfilteranordnung (10) nach Anspruch 7,
**dadurch gekennzeichnet, dass**
die Lochfolie eine Vielzahl von Löchern mit einem Durchmesser von etwa 0,8 mm aufweist.

9. Staubfilteranordnung (10) nach Anspruch 7 oder 8,
**dadurch gekennzeichnet, dass**
die Lochfolie eine Dicke von wenigstens 0,47 mm aufweist.

10. Staubfilteranordnung (10) nach einem der Ansprüche 7 bis 9, **dadurch gekennzeichnet, dass**
die Lochfolie etwa 450 Löcher pro Zoll aufweist.

11. Staubfilteranordnung (10) nach einem der Ansprüche 7 bis 10, **dadurch gekennzeichnet, dass**
die Lochfolie aus einem glatten Material besteht, so dass der Staubfilter (12) durch Abwischen der Lochfolie reinigbar ist.

12. Staubfilteranordnung (10) nach einem der Ansprüche 6 bis 11, **dadurch gekennzeichnet, dass**
der Staubfilter (12) aus einem Kunststoffmaterial gefertigt ist.
